# DEMANDE DE BREVET EUROPEEN

(11) **EP 0 578 557 A1**
(43) Date de publication de la demande: **12.01.1994**
(21) Numéro de dépôt: 93401746.8
(22) Date de dépôt: 06.07.1993
(51) Int. Cl.: H01L 31/0352, H01L 31/0304

(54) **Détecteur d'ondes électromagnétiques à puits quantiques**

(30) Priorité: 07.07.1992 FR 9208384
(71) Demandeur: THOMSON-CSF, 75008 Paris (FR)
(72) Inventeur: Bois, Philippe, F-92402 Courbevoie Cedex (FR); Rosencher, Emmanuel, F-92402 Courbevoie Cedex (FR); Vinter, Borge, F-92402 Courbevoie Cedex (FR); Massies, Jean, F-92402 Courbevoie Cedex (FR); Neu, Gérard, F-92402 Courbevoie Cedex (FR); Grandjean, Nicolas, F-92402 Courbevoie Cedex (FR)
(74) Mandataire: Guérin, Michel

(57) **Abrégé**

Détecteur d'ondes électromagnétiques en semiconducteurs, comprenant au moins un puits quantique dans lequel est prévue une fine couche d'un matériau de largeur de bande interdite inférieure à celle de la couche de puits quantique.

Par exemple dans le cas d'un puits quantique GaAlAs/GaAs/GaAlAs, on prévoit une fine couche d'InAs.

De cette façon, on augmente la différence des niveaux d'énergie entre les deux niveaux permis e₁-e₂.

Applications : Détection de courtes longueurs d'ondes (3-5 µm par exemple).

## Description

L'invention concerne un détecteur d'ondes électromagnétiques en matériau semiconducteur à puits quantique et notamment un détecteur permettant de détecter des ondes de longueurs d'ondes plus courtes que celles détectées par les détecteurs connus.

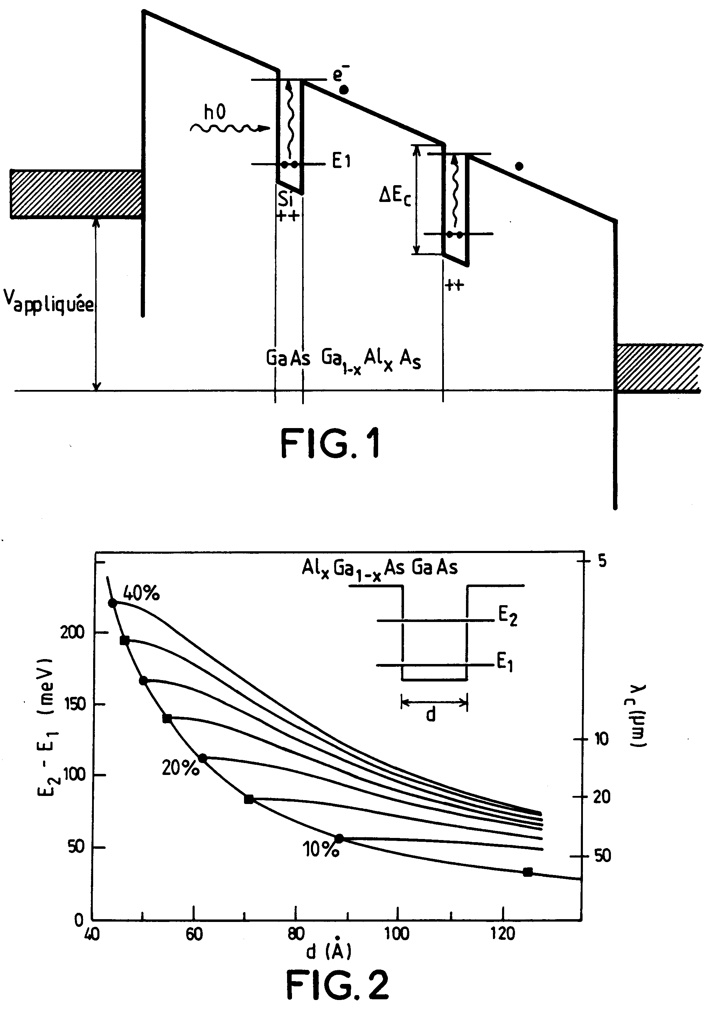

Les progrès rapides de la croissance par épitaxie sur substrats GaAs ont permis le développement d'une nouvelle classe de détecteurs d'ondes électromagnétiques utilisant des transitions intrabandes dans des puits quantiques comme cela est représenté en figure 1 et décrit dans le document E. ROSENCHER et P. BOIS, Physical Review, B44, 11315 (1991).

L'évolution récente des performances de ce type de composants est liée en particulier à la réalisation relativement facile de multicouches de semiconducteurs à hétérojonctions dans le système standard de l'épitaxie par jets moléculaires (MBE), c'est-à-dire le système GaAs/Ga₁₋ₓAlₓAs. En ajustant les paramètres de croissance, l'épaisseur des puits quantiques et le pourcentage x d'Aluminium dans les barrières imposant le potentiel de confinement, on peut choisir de centrer une bande étroite (environ 1 µm) de détection sur une longueur d'onde donnée (voir figure 2). Cependant, l'utilisation du système standard GaAs/Ga₁₋ₓAlₓAs avec 0 ≦ x ≦ 43 % entraîne une limitation en longueur d'onde dans la gamme 7-20 µm. Pour pallier cette limitation, et en particulier étendre vers la bande 3-5 µm, plusieurs solutions ont déjà été envisagées.

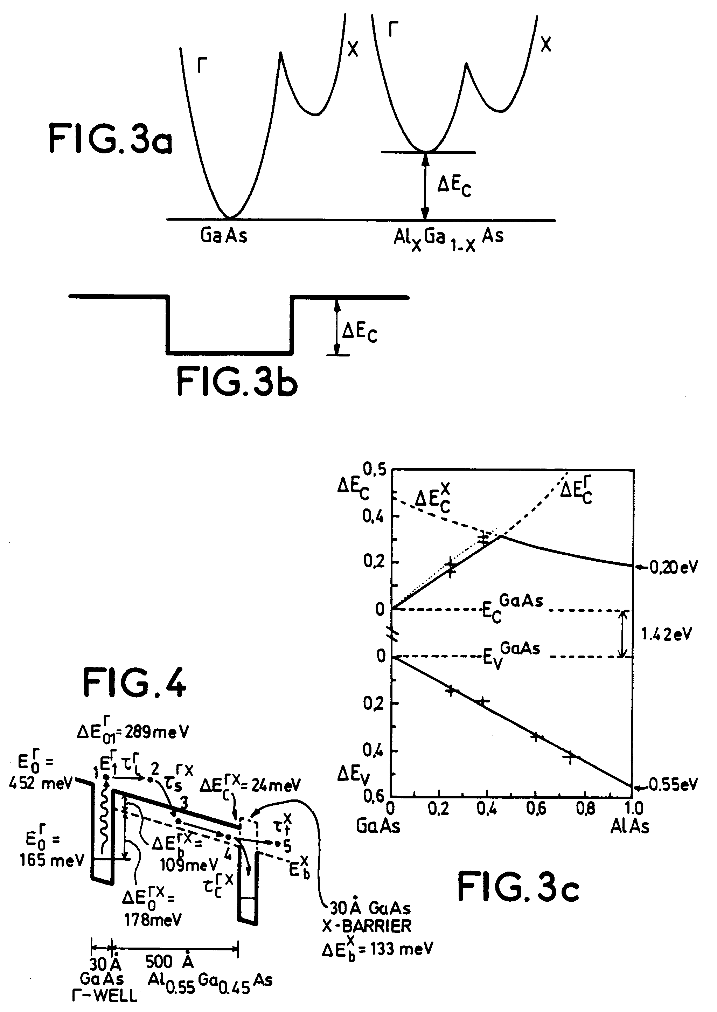

La première consiste à augmenter le pourcentage d'Aluminium de la barrière au-delà de 43 %. Cependant, bien que l'on conserve des matériaux avec des conditions de croissance "standard", cette solution n'est pas optimale pour des raisons liées à la structure de bandes des matériaux III-V. En effet, augmenter x revient bien à augmenter le potentiel de confinement et donc l'énergie d'excitation optique mais à cause des croisements des bandes X et Γ (voir figures 3a à 3c) l'énergie d'excitation thermique reste faible (de l'ordre de 120 meV). Pour cette raison, le détecteur présenté figure 4 aura effectivement une réponse optique dans la gamme 3-5 µm, mais avec le rapport signal/bruit et donc la température de BLIP d'un détecteur à multipuits quantiques opérant dans la gamme 8-12 µm, c'est-à-dire T_{BLIP} ∼ 70 K.

La deuxième solution consiste à choisir délibérément d'autres couples de semiconducteurs III-V comme GalnAs/AlInAs épitaxiés sur InP par MOCVD. Ce choix permet d'obtenir des composants optimaux du point de vue des limitations intrinsèques mais a le désavantage d'utiliser des technologies moins classiques et donc plus délicates.

Le but de cette invention est de modifier légèrement le système de matériaux utilisés pour qu'il reste proche du standard MBE, donc facile à réaliser.

L'invention concerne donc un détecteur d'ondes électromagnétiques en matériau semiconducteur à puits quantique comprenant au moins une première couche de puits quantique enserrée entre une deuxième et une troisième couches barrières, la largeur de bande interdite de la première couche étant inférieure à celles des deuxième et troisième couches, caractérisé en ce que la première couche de puits comporte au moins une couche supplémentaire en matériau semiconducteur de largeur de bande interdite inférieure à celle de la première couche et d'épaisseur inférieure ou égale à celle de l'épaisseur du puits.

L'invention concerne également un détecteur d'onde électromagnétique en matériau semiconducteur à puits quantique comprenant au moins une première couche de puits quantique enserrée entre une deuxième et une troisième couches barrières la largeur de bande interdite de la première étant inférieure à celles des deuxième et troisième couches, la première couche étant en GaAs et les deuxième et troisième couches étant en AlₓGa₁₋ₓAs, caractérisé en ce que la première couche comporte également de l'indium.

Les différents objets et caractéristiques de l'invention apparaîtront plus clairement dans la description qui va suivre et dans les figures annexées qui représentent :
- la figure 1, un diagramme de bande de conduction illustrant le fonctionnement d'un détecteur à puits quantiques ;
- la figure 2, des couches donnant, pour des détecteurs à puits quantique GaAs/Ga₁₋ₓAlₓAs ayant différente concentration x d'Aluminium, les valeurs des différences d'énergie entre deux niveaux d'énergie d'électrons dans les puits quantiques ;
- les figures 3a à 3c, des courbes montrant la discontinuité de la bande de conduction d'un puits quantique GaAs/GaAlAs lorsque la concentration varie entre 0 et 100 % ;
- la figure 4, un diagramme de bande de conduction illustrant le mécanisme de conduction électronique ;
- la figure 5a, un dispositif à puits quantique selon l'invention ;
- les figures 5b, 5c, des diagrammes de bandes de conduction mettant en évidence l'intérêt de l'invention ;
- la figure 6, des courbes donnant pour un puits quantique GaAs/Ga₁₋ₓAlₓAs modifié selon l'invention et pour différentes valeurs de x, les différences d'énergie entre deux niveaux d'énergie du puits quantique ;
- les figures 7 et 8, des diagrammes de bandes de conduction d'un dispositif selon l'invention.

Le dispositif selon l'invention comporte un puits quantique dans lequel on prévoit dans la couche de puits quantique, une couche d'épaisseur de quelques atomes en un matériau dont la largeur de bande interdite est inférieure à celle du matériau constituant la couche du puits. Par exemple dans un puits en GaAs/GaAlAs, il s'agit d'introduire dans le matériau du puits quelques couches atomiques de matériau à plus petite largeur de bande interdite comme par exemple Ga_{1-y}In_{y}As avec 0 ≦ y ≦ 1 afin de baisser l'énergie du premier niveau permis par rapport à l'énergie des barrières de GaAlAs.

La figure 5a illustre un tel dispositif comprenant au moins un puits quantique 1, 1', 10 enserré entre deux couches barrières 2 et 3, lesquelles sont enserrées entre deux couches 4 et 5 permettant d'obtenir des contacts ohmiques. Des contacts métalliques 6 et 7 sont situés sur les couches 4 et 5. Le contact 6 laisse une partie de la surface extérieure de la couche 5 découverte permettant ainsi à un flux lumineux d'atteindre la partie active du dispositif. Le contact 6 pourrait également être transparent à l'onde lumineuse à détecter et pourrait alors recouvrir toute la couche 5.

Le puits quantique comporte dans les couches 1, 1', une couche 10 d'épaisseur de quelques atomes.

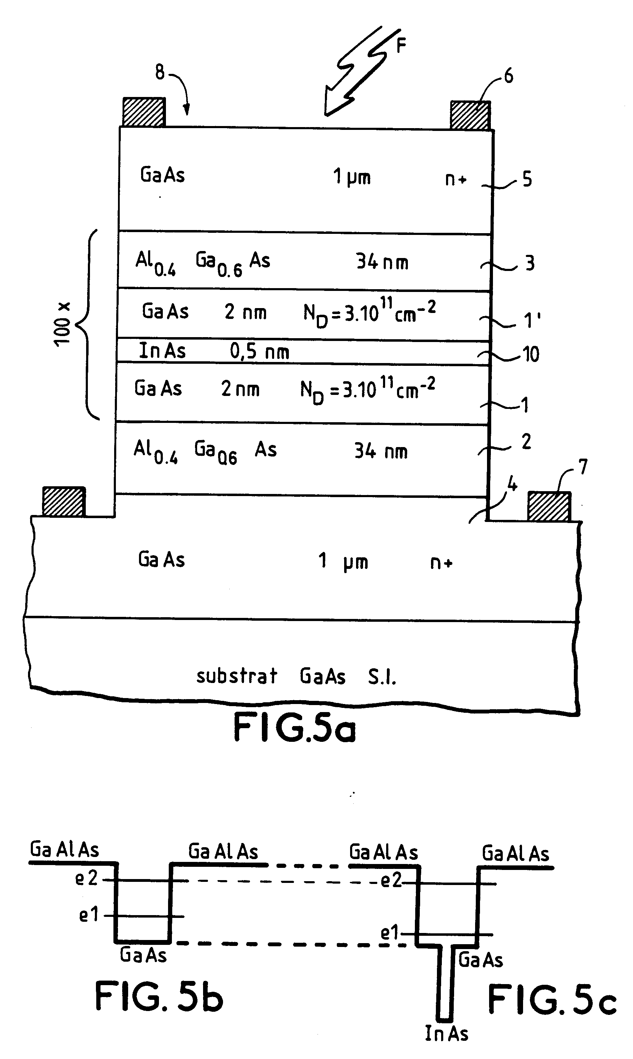

Les figures 5b et 5c représentent des diagrammes de bandes de conduction mettant en évidence l'intérêt de l'invention.

Le diagramme de la figure 5b correspond à une structure telle que celle de la figure 5a mais dans laquelle il n'a pas été prévu de couche 10. Le puits quantique de la figure 5b comporte deux niveaux el et e2 dont la différence des énergies correspond à une onde λ₁ susceptible d'être détectée.

En prévoyant une couche 10 de faible largeur de bande interdite on obtient une bande de conduction du type représenté en figure 5c. Il apparaît alors que le niveau el est d'énergie plus faible ce qui accroît la différence d'énergie des niveaux e1-e2 qui correspond alors à une longueur d'onde plus faible.

En fonctionnement en détecteur, le dispositif de la figure 5a permet alors de détecter des longueurs d'ondes plus faibles.

Dans le cas d'un puits quantique constitué de couches de puits 1, 1' en GaAs et de couches barrières 2, 3 en Ga₁₋ₓAlₓAs, on prévoit au moins une couche 10 en InAs.

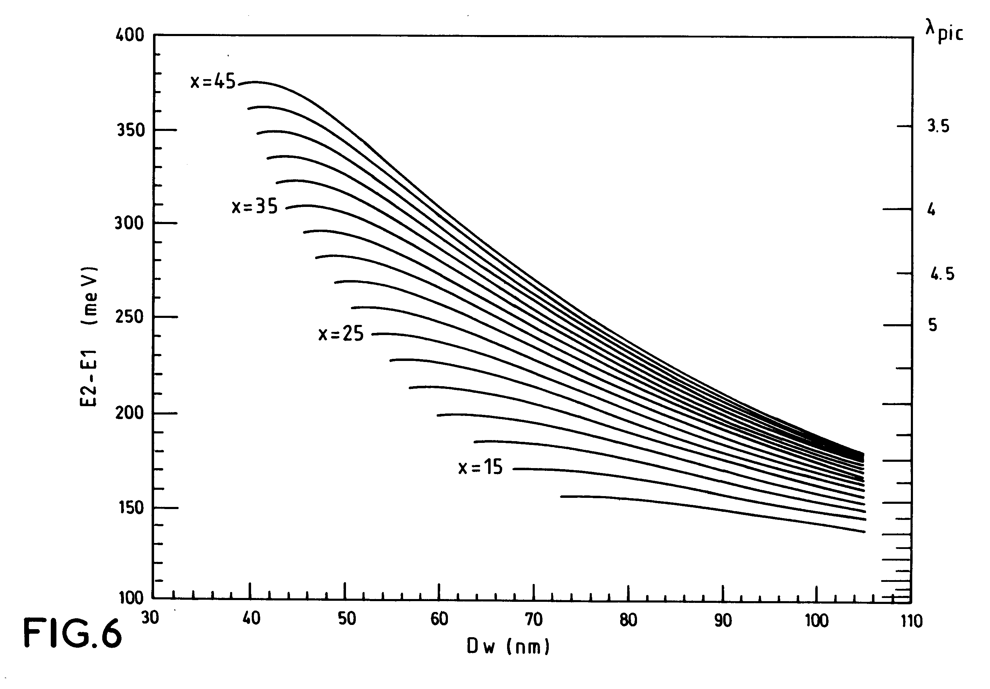

La figure 6 représente les possibilités offertes par l'introduction d'une couche 10 de 0,5 nm d'épaisseur (1,5 monocouche atomique). Les différentes courbes correspondent à différentes compositions en aluminium des couches barrières. On voit alors que le dispositif de l'invention permet de détecter des longueurs d'ondes comprises entre sensiblement 3 et 7 µm tandis que, sans prévoir de couche 10, on pourrait détecter des longueurs d'ondes comprises entre 7 et 20 µm (voir figure 2).

On voit qu'il est ainsi possible d'étendre les potentialités de ce type de détecteurs à multipuits quantiques jusqu'à 3.2 µm, donc dans la bande 3-5 µm inaccessible auparavant. Ceci est réalisé sans introduire de modifications radicales ni dans les procédés de croissance, ni dans les procédés technologiques et tout en conservant les propriétés thermiques inhérentes à ce type de détecteur (T_{BLIP} plus élevée).

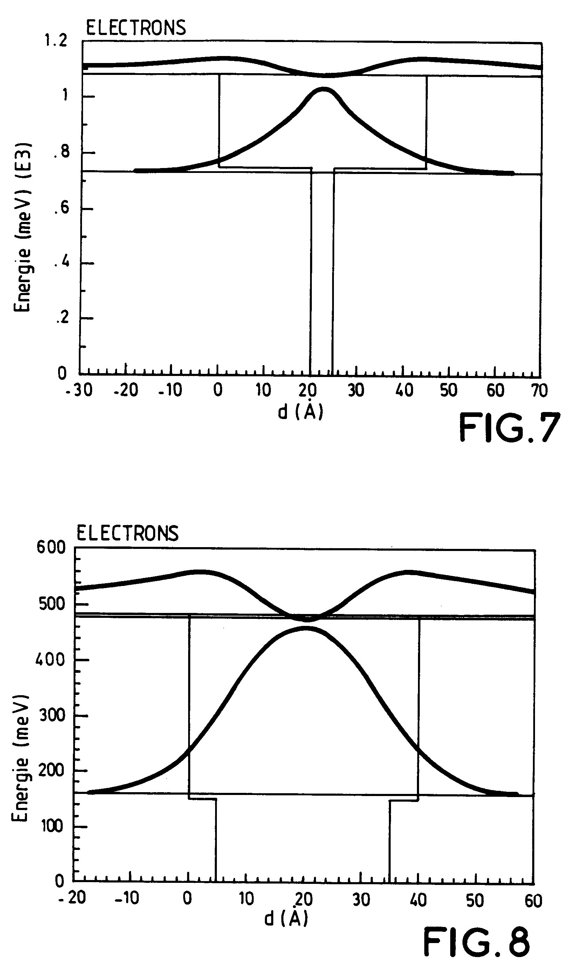

La figure 7 montre à titre d'exemple le profil de bande de conduction d'un détecteur à λ_{pic} ∼ 3.9 µm, dont la couche active est un empilement de couches barrière Ga_{0.6}Al_{0.4}As de 34 nm, et de puits formé par 4 nm de GaAs dopé Si et 0.5 nm d'InAs.

Il est possible également d'utiliser comme couches additionnelles des couches de Ga_{0.8}In_{0.2}As et la figure 8 montre à titre d'exemple le profil de bande de conduction d'un détecteur à λ_{pic} ∼ 3.6 µm formé avec le même matériau barrière.

Selon une variante on prévoit même que la couche de puits est en GaInAs dans toute son épaisseur et que les barrières sont en GaAs. L'idée de prévoir de l'indium dans le puits fait partie de l'invention et n'était pas évident à réaliser en raison des différences de paramètres de mailles et en raison de la ségrégation de l'indium lors de la croissance.

Dans les exemples de réalisation qui précèdent on a décrit des dispositifs en GaAs/GaAlAs permettant de fonctionner à de courtes longueurs d'ondes (3 µm par exemple). L'invention est également utilisable pour des détecteurs à de grandes longueurs d'ondes (8 - 12 µm) et l'avantage de l'invention est alors d'obtenir une réponse de 5 à 10 fois meilleur en prévoyant notamment des couches de GaAlAs à 5 % d'aluminium par exemple.

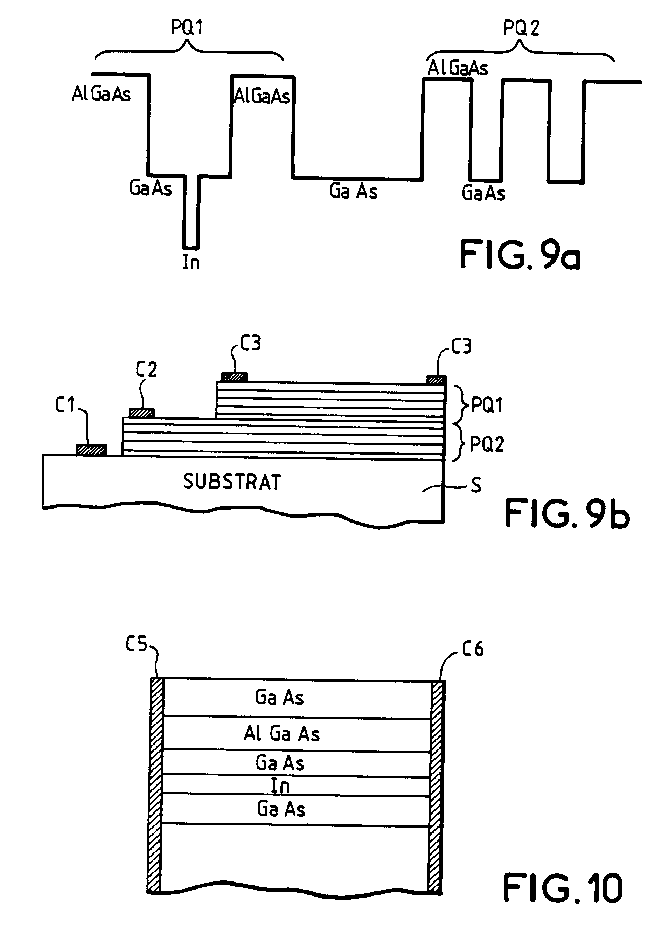

Le dispositif de l'invention peut également être appliqué à la réalisation d'un détecteur de deux types de longueurs d'ondes (ou détecteur bicouleur). Par exemple, comme cela est représenté en figures 9a et 9b, il comporte un premier empilement de couches PQ1 constituant un premier puits quantique conforme à l'invention pour détecter de petites longueurs d'ondes (3-5 µm par exemple) et un deuxième empilement de couches PQ2 constituant un deuxième puits quantique pour détecter des longueurs d'ondes plus grandes que les précédentes.

Par exemple le premier empilement PQ1 peut être à base de Ga₁₋ₓAlₓAs/GaAs avec au moins une couche d'indium (ou d'InAs) dans la couche du puits. Le deuxième empilement PQ2 peut être à base de Ga₁₋ₓAlₓAs/GaAs.

Un tel dispositif présente l'intérêt d'être fabriqué avec les mêmes matériaux pour les deux détecteurs et cela dans un même bâti d'épitaxie.

La géométrie d'un tel détecteur peut être telle que celle représentée à titre d'exemple sur la figure 9b. Elle est telle que sur un substrat S se trouve l'empilement PQ1 servant à détecter les longueurs d'ondes d'une première gamme (courtes par exemple) entre les contacts ohmiques C1 et C2. Sur l'empilement PQ1, se trouve l'empilement PQ2 servant à détecter les longueurs d'ondes d'une gamme de longueurs d'ondes plus élevées entre les contacts ohmiques C2 et C3.

L'invention est également applicable à la réalisation de bolomètres. Dans ce cas les contacts ohmiques C5, C6 servant à mesurer la résistivité du dispositif sont situés sur les flancs des couches comme cela est représenté sur la figure 10.

## Revendications

1. Détecteur d'ondes électromagnétiques en matériau semiconducteur à puits quantique comprenant au moins une première couche de puits quantique (1, 1') enserrée entre une deuxième et une troisième couches barrières (2, 3), la largeur de bande interdite de la première couche étant inférieure à celles des deuxième et troisième couches, caractérisé en ce que la première couche de puits comporte au moins une couche supplémentaire (10) en matériau semiconducteur de largeur de bande interdite inférieure à celle de la première couche et d'épaisseur, l'épaisseur d'une ou de quelques couches atomiques.

2. Détecteur d'onde électromagnétique en matériau semiconducteur à puits quantique comprenant au moins une première couche de puits quantique (1, 1') enserrée entre une deuxième et une troisième couches barrières (2, 3) la largeur de bande interdite de la première étant inférieure à celles des deuxième et troisième couches, la première couche étant en GaAs et les deuxième et troisième couches étant en AlₓGa₁₋ₓAs, caractérisé en ce que la première couche comporte également de l'indium.

3. Détecteur selon la revendication 1, caractérisé en ce que l'épaisseur de la couche supplémentaire est sensiblement égale à l'épaisseur d'une ou de quelques couches atomiques.

4. Détecteur selon la revendication 1, caractérisé en ce que le puits quantique est à base de GaAs pour la première couche de puits quantique (1, 1') et de AlGaAs pour les deuxième et troisième couches barrières (2, 3) et en ce que la couche supplémentaire (10) est à base de InAs.

5. Détecteur selon la revendication 2, caractérisé en ce que la couche supplémentaire (10) est du Ga_{1-y}In_{y}As, y étant compris entre 0 et 1 et différent de 0.

6. Détecteur selon la revendication 2, caractérisé en ce qu'il comporte de part et d'autre des deuxième et troisième couches des couches de contact en GaAs dopé qui portent les contacts métalliques.

7. Détecteur selon la revendication 2, caractérisé en ce que l'épaisseur de la première couche de puits quantique (1, 1') est de quelques nanomètres et les épaisseurs des deuxième et troisième couches barrières (2, 3) de quelques dizaines de nanomètres.

8. Détecteur selon la revendication 2, caractérisé en ce que les deuxième et troisième couches barrières (2, 3) sont en Ga₁₋ₓAlₓAs, x étant compris entre 0,1 et 0,5.

9. Détecteur caractérisé en ce qu'il comporte un premier empilement de couches (PQ1) selon la revendication 1, pour détecter une longueur d'onde située dans une première gamme de longueurs d'ondes donnée et un deuxième empilement de couches (PQ2) superposé ou précédent pour détecter une autre longueur d'onde située dans une deuxième gamme de longueurs d'ondes.

10. Application du détecteur selon la revendication 1 à un bolomètre, caractérisé en ce qu'il comprend des contacts ohmiques situés sur des flancs des couches.
